# EUROPÄISCHE PATENTSCHRIFT

(11) **EP 2 616 753 B1**
(45) Veröffentlichungstag und Bekanntmachung des Hinweises auf die Patenterteilung: **14.12.2016**
(21) Anmeldenummer: 11764132.4
(22) Anmeldetag: 16.09.2011
(51) Int. Cl.: F26B 5/00

(54) **ERWÄRMUNGS- UND TROCKNUNGSVORRICHTUNG**
HEATING AND DRYING DEVICE
DISPOSITIF DE CHAUFFAGE ET DE SÉCHAGE

(30) Priorität: 17.09.2010 DE 202010012737 U
(43) Veröffentlichungstag der Anmeldung: 24.07.2013
(73) Patentinhaber: Asscon Systemtechnik-Elektronik GmbH, 86343 Königsbrunn (DE)
(72) Erfinder: ZABEL, Claus, 86199 Augsburg - Göggingen (DE)
(74) Vertreter: Wegner, Hans
(86) Internationale Anmeldenummer: PCT/EP2011/066120
(87) Internationale Veröffentlichungsnummer: WO 2012/035143

(56) Entgegenhaltungen:
- DE-U1-202009 011 836
- US-A- 3 953 381
- US-A- 4 874 124
- US-A- 5 183 067

## Beschreibung

### 1. Technisches Gebiet

Die vorliegende Erfindung betrifft eine Erwärmungs- und Trocknungsvorrichtung für Werkstücke.

### 2. Stand der Technik

In vielen Bereichen der Industrie müssen Prozess- und Bearbeitungsschritte in einem bestimmten engen Temperaturbereich ablaufen. Dieser Bereich befindet sich oft bei Temperaturen, die deutlich höher als die Raumtemperatur sind. Es besteht deshalb häufig die Notwendigkeit elektrische, optische und/oder mechanische Komponenten gezielt auf eine geforderte Prozess- oder Bearbeitungstemperatur aufzuheizen. Insbesondere empfindliche Bauteile oder Komponenten, die Funktionen aus verschiedenen Gebieten kombinieren wie etwa elektrooptische und/oder elektromagnetische Komponenten stellen häufig große Anforderungen an Aufheiz- und Abkühlprozesse, um den Erfolg nachfolgender Prozess- oder Bearbeitungsschritte nicht zu gefährden. Häufig weist die für einen Prozessschritt vorgegebene Soll-Temperatur ein sehr kleines Prozessfenster auf, zum Beispiel eine Abweichung von der Soll-Temperatur von weniger als ± 3 °C. Die geforderten Temperaturprofile können häufig nur mit Hilfe einer Steuerung oder Regelung des Erwärmungsprozesses eingehalten werden.

Beispielhafte Prozess- und Bearbeitungsschritte, die bei Temperaturen ablaufen, die deutlich oberhalb der Raumtemperatur liegen, sind das Polymerisieren von Kunststoffen oder Lacken, das Schmelzen von metallischen Legierungen, Gefügeumwandlungen in Metallen durch eine entsprechende Temperaturbehandlung oder das gezielte Verbinden oder Trennen von Komponenten oder Bauteilen im Rahmen von Löt- oder Klebeprozessen.

Der Kontakt des zum Aufheizen verwendeten Mediums mit der zu erwärmenden Komponente darf letztere in keiner Weise verändern. Beispiele nachteiliger Effekte sind Korrosionsvorgänge durch chemische Reaktionen, Ablagerungen auf der Oberfläche der Komponente oder das Bilden von elektrischen Kurzschlüssen. Dabei ist zu beachten, dass chemische Reaktionen bei höheren Temperaturen in der Regel schneller ablaufen oder erst in Gang gesetzt werden.

Im Folgenden werden Komponenten und/oder Bauteile und/oder Halbzeuge übergreifend als Werkstücke bezeichnet.

Die Patentschrift US 3 953 381 offenbart eine homogene Flüssigkeitszusammensetzung, die zur Behandlung von Oberflächen zum Entfernen von Wasser und anderen Materialien eingesetzt wird. Die Flüssigkeitszusammensetzung ist zusammengesetzt aus 90 bis 99,95 Gewichts-% eines Lösungsmittels, das zumindest 50 Gewichts-% an 1,1,2-Trichlor-1,2,2-Trifluorethan und 0,05 bis 10 Gewichts-% eines oder mehrerer Diamide mit der allgemeinen Formel 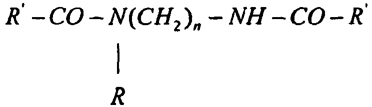 aufweist, wobei R ein gesättigter oder ungesättigter aliphatischer Kohlenwasserstoff ist, der 1 bis 25 Kohlenstoffatome aufweist, wobei *R* eine aliphatische Kohlenwasserstoffgruppe ist, die 10 bis 30 Kohlenwasserstoffatome aufweist und zumindest eine ethylenische Doppelbindung aufweist und n eine Zahl zwischen 1 und 9 ist.

Die Gebrauchsmusterschrift DE 20 2009 011 836 U1 offenbart eine Maschine zur Trocknung von Werkstücken nach einer wässrigen Reinigung in einem mit halogeniertem Ether oder einem Hydro-Fluor-Ether gefüllten Tauchbecken. Über dem Tauchbecken wird eine Dampfzone angeordnet und darüber eine Trockenzone, die mit Tiefkühlmitteln gekühlt wird.

Die Patentschrift US 4 874 124 offenbart das Schweißen oder Löten elektronischer Komponenten auf eine Auflage, auf deren Oberfläche die elektronischen Komponenten angeordnet sind und/oder in Löchern, die die Auflage durchbohren. In der Gegenwart des Lötmaterials, das Bindungseigenschaften aufweist, wird die Anordnung in Kontakt mit einem Perfluropolyether in flüssigem Zustand gebracht, wobei der Perfluoropolyether eine Temperatur aufweist, bei der das Lötmaterial seine Bindungseigenschaften entwickelt.

In dem Stand der Technik sind derzeit viele Verfahren bekannt, um Werkstücke zu erwärmen. Als Beispiele seien hier die kontaktlosen Aufheizverfahren genannt, die elektromagnetische Strahlung aus verschiedenen Wellenlängenbereichen verwenden wie etwa Mikrowellenstrahlung, Infrarot-Strahlung oder Laser-Strahlung. Ferner kann die Konvektion eines Gases, das einem Temperaturgradienten unterworfen ist, zum Aufheizen von Werkstücken eingesetzt werden. Ein Erwärmungsverfahren, das bei elektrisch leitfähigen Komponenten zum Einsatz gebracht werden kann, ist die elektromagnetische Induktion. Erwärmungsverfahren, bei denen die zu erwärmende Komponente in Kontakt mit dem zur Erwärmung eingesetzten Medium kommt, sind beispielsweise das Eintauchen in heiße Flüssigkeiten.

Die genannten Verfahren weisen jedoch bei komplexen Prozessanforderungen und/oder schwierig zu bearbeitenden Werkstücken zum Teil gravierende Nachteile auf. Nachfolgend werden einige der bekannten Nachteile beispielhaft aufgeführt. Falls die zu erwärmenden Werkstücke eine große Masse aufweisen, können lange Aufheiz- und Abkühlzeiten entstehen, die sich negativ in dem gesamten Herstellungsprozess eines Produkts auswirken, in das das für die nachfolgende Prozessierung zu erwärmende Werkstück schließlich eingebaut wird. Eine ungleichmäßige Energie- oder Wärmezufuhr auf das zu erwärmende Werkstück führt zu lokalen Temperaturunterschieden innerhalb des Werkstücks, die mechanische Spannungen in dem Werkstück hervorrufen. Empfindliche Werkstücke, die sich insbesondere aus mehreren verschiedenen Materialien zusammensetzen, die unterschiedliche thermische Ausdehnungskoeffizienten aufweisen, können durch den Aufheizprozess Schaden nehmen. Durch eine ungleichmäßige Wärmezufuhr auf das Werkstück kann dieses, insbesondere beim Aufweisen einer komplexen Geometrie und/oder einer komplizierten Materialzusammensetzung, am Ende des Erwärmungsvorgangs über sein Volumen und seine Oberfläche hinweg eine Temperaturverteilung aufweisen. Dadurch kann der Erfolg der an dem erwärmten Werkstück erfolgenden Prozess- oder Bearbeitungsschritte gefährdet werden. Das Problem möglicher Oberflächenveränderungen beispielsweise durch eine Oxidationsreaktion wurde bereits oben angesprochen.

Um die beschriebenen Schwierigkeiten zu verringern, wurden zum Teil komplexe Anlagentechnologien entwickelt. Diese erfordern mitunter hohe werkstück-spezifische Investitionskosten, wodurch der Produktionsprozess durch Rüstzeiten verlangsamt und verteuert wird. Zudem sind eine komplexe Anlagentechnologie und eine reduzierte Steuer- und/oder Regelbarkeit von Aufheizprozessen häufig gekoppelt. Ein in der Zukunft deutlich an Bedeutung gewinnendes Thema ist ein hoher Energieverbrauch, der durch einen schlechten Wirkungsgrad bei der Energie- oder Wärmeübertragung von der Energiequelle auf das Werkstück entsteht.

Die Erwärmung eines Werkstücks in einem Flüssigkeitsbad führt zu einer gleichmäßigen und gut kontrollierbaren Energiezufuhr über die gesamte Oberfläche des Werkstücks und vermeidet damit einen Großteil der diskutierten Probleme.

Für die nachfolgenden weiteren Verarbeitungs- oder Prozessschritte muss das erwärmte Werkstück häufig trocken sein. Bei den Erwärmungsvorgängen bei denen das Werkstück in eine Flüssigkeit eintaucht, können deshalb aufwändige Trocknungsmaßnahmen nötig werden, um die Reste der zur Erwärmung verwendeten Flüssigkeit von der Oberfläche des Werkstücks zu entfernen. Dieses Problem kann insbesondere dann auftreten, wenn das zu erwärmende Werkstück eine komplexe Oberfläche aufweist und/oder wenn es viele innere Hohlräume aufweist, in die das für die Erwärmung verwendete Medium eindringen kann. Die in inneren Hohlräumen des heißen Werkstücks verbleibenden Reste oder Ablagerungen des Erwärmungsmediums können den Erfolg nachfolgender Prozessschritte gefährden. Beispielsweise führt das Aufbringen einer Lackschicht auf das aufgeheizte Werkstück zu einer fehlenden oder mangelhaften Schicht an den Stellen an denen sich Reste des Erwärmungsmediums abgesetzt haben. Deshalb müssen erwärmte Werkstücke vor der weiteren Prozessierung häufig in eigens dafür vorgesehenen Trocknungsvorrichtungen von Flüssigkeitsresten befreit werden.

Der vorliegenden Erfindung liegt daher das Problem zu Grunde, eine Vorrichtung anzugeben mit der ein Werkstück gleichmäßig erwärmt und auch getrocknet werden kann und die es ermöglicht, die diskutierten Nachteile weitgehend zu vermeiden.

### 3. Zusammenfassung der Erfindung

Gemäß der vorliegenden Erfindung wird dieses Problem durch eine Vorrichtung nach Anspruch 1 gelöst. In einer Ausführungsform weist eine Vorrichtung zum Erwärmen und zum Trocknen eines Werkstücks mit Hilfe zumindest einer inerten, elektrisch nicht leitenden Flüssigkeit und deren Dampf, wobei der Dampf der zumindest einen inerten, elektrisch nicht leitenden Flüssigkeit eine höhere Dichte als Luft aufweist, zumindest einen Behälter auf, der ausgebildet ist, die zumindest eine Flüssigkeit und/oder deren Dampfdecke und das Werkstück aufzunehmen; zumindest eine Positioniervorrichtung auf, die ausgebildet ist, das Werkstück in den zumindest einen Behälter einzubringen und wieder aus dem zumindest einen Behälter zu entfernen; zumindest eine Heizvorrichtung auf, die ausgebildet ist, die zumindest eine Flüssigkeit auf zumindest eine erste Temperatur und auf eine zweite Temperatur zu erwärmen; wobei die zumindest eine Flüssigkeit bei der zweiten Temperatur eine Dampfdecke bildet, wobei die Positioniervorrichtung das Werkstück aus der zumindest einen Flüssigkeit in die Dampfdecke der zumindest einen Flüssigkeit befördert, wenn das Werkstück die zumindest erste Temperatur erreicht hat; und wobei die Vorrichtung das Werkstück nach Erreichen einer vorgegebenen Soll-Temperatur aus der Dampfdecke befördert.

In einem anderen Aspekt weist die Dampfdecke gesättigten Dampf der zumindest einen Flüssigkeit auf und die zweite Temperatur entspricht der Siedetemperatur der zumindest einen Flüssigkeit oder die Dampfdecke umfasst ungesättigten Dampf der zumindest einen Flüssigkeit und die zweite Temperatur liegt oberhalb der Siedetemperatur der zumindest einen Flüssigkeit.

Die verschiedenen Ausführungsformen der erfindungsgemäßen Vorrichtung heizen das zu erwärmende Werkstück im Bad einer inerten, elektrisch nicht leitenden Flüssigkeit bis in die Nähe der Siedetemperatur der Flüssigkeit auf. Diese Temperatur wird im Folgenden als erste Temperatur bezeichnet. Dieser Vorgang weist mehrere wesentliche Vorzüge auf. Zum einen erfolgt das Aufheizen mit großem Wirkungsgrad, da das Werkstück vollständig in die Flüssigkeit eintaucht. Zum anderen geschieht das Erwärmen für das Werkstück sehr schonend, da durch die gleichmäßige Energiezufuhr über die gesamte Oberfläche einschließlich der inneren Oberflächen der in dem Werkstück vorhandenen Hohlräume geringe innere mechanische Spannungen garantiert sind. Darüber hinaus sorgt die inerte, elektrisch nicht leitende Flüssigkeit dafür, dass in oder an der Oberfläche des Werkstücks keinerlei chemische Reaktionen ablaufen.

In einer ersten Ausführungsform erfolgt der letzte kleine Aufheizschritt von der ersten Temperatur zur zweiten Temperatur, die der Siedetemperatur der Flüssigkeit entspricht, in einer Dampfdecke über der siedenden Flüssigkeit, d.h. in deren gesättigten Dampf. Nachdem das Werkstück die zweite Temperatur erreicht hat, wird es aus der Dampfdecke herausgefahren. Zu diesem Zeitpunkt ist das Werkstück noch von einem während des Aufheizens durch Kondensation gebildeten, dünnen Flüssigkeitsfilm umhüllt. Dieser verdunstet nach dem Herausfahren durch die im Werkstück gespeicherte Wärmeenergie rückstandsfrei ohne das Werkstück merklich abzukühlen. Das Werkstück weist dann auf seiner Oberfläche überall die gleiche Temperatur auf und ist vollständig trocken, wodurch das erfolgreiche Durchführen der nachfolgenden Prozess- bzw. Verarbeitungsschritte sichergestellt wird.

In einer zweiten Ausführungsform wird für den letzten Aufheizschritt ungesättigter Dampf eingesetzt. Damit kann das Werkstück über die Siedetemperatur der Flüssigkeit hinaus erwärmt werden und somit der Temperaturbereich des Aufheizvorgangs zu höheren Temperaturen hin erweitert werden. Überschreitet die Temperatur des Werkstücks die Siedetemperatur so verdampft die Flüssigkeit von der gesamten Oberfläche des Werkstücks. Oberhalb der Siedetemperatur verdampfen auch Flüssigkeitsansammlungen oder Flüssigkeitsreste die schöpfende Werkstücke, d.h. Werkstücke mit Hohlräumen oder Kavitäten während des Aufheizens in dem Flüssigkeitsbad aufgenommen haben. Wird das Werkstück bei einer Soll-Temperatur, die oberhalb der Siedetemperatur liegt aus dem Dampf herausgenommen, ist das Werkstück bereits trocken.

Die erfindungsgemäße Vorrichtung verwirklicht einen Erwärmungs- und Trocknungsprozess in einer einzigen Vorrichtung, die mit einem einzigen Wärmeübertragungsmedium auskommt. Eigens entwickelte oder angepasste Trocknungsvorrichtungen können entfallen. Die einfache und robuste erfindungsgemäße Vorrichtung ermöglicht darüber hinaus eine zuverlässige und reproduzierbare Prozessführung.

In einem weiteren Aspekt ist die Heizvorrichtung ausgebildet, die zumindest eine Flüssigkeit von einer Raumtemperatur ausgehend auf die zumindest eine erste und die zweite Temperatur zu erwärmen.

Gemäß der Erfindung weist die Heizvorrichtung ferner eine Steuerungseinheit auf, die ausgebildet ist, einen Temperaturanstieg der zumindest einen Flüssigkeit bis zu der zweiten Temperatur nach einem vorgegebenen Temperaturprofil zu steuern, oder es weist die Heizvorrichtung ferner eine Regelungseinheit auf, die ausgebildet ist, den Temperaturanstieg der zumindest einen Flüssigkeit bis zu der zweiten Temperatur gemäß eines vorgegebenen Temperaturprofils nachzubilden.

In noch einem anderen Aspekt weist der zumindest eine Behälter zumindest einen ersten und einen zweiten Behälter auf, wobei eine Temperatur der zumindest einen Flüssigkeit in dem zumindest einen ersten Behälter der zumindest einen ersten Temperatur entspricht und eine Temperatur der zumindest einen Flüssigkeit in dem zweiten Behälter der zweiten Temperatur entspricht.

Gemäß einem anderen Aspekt umfasst der zumindest eine erste Behälter zumindest einen weiteren Behälter, dessen Flüssigkeit eine Temperatur aufweist, die zwischen einer Ausgangstemperatur und der ersten Temperatur der zumindest einen Flüssigkeit liegt.

In einem anderen vorteilhaften Aspekt befördert die Positioniervorrichtung das Werkstück für zumindest ein erstes Zeitintervall in den zumindest einen ersten Behälter und befördert das Werkstück nach Ablauf des zumindest einen ersten Zeitintervalls für ein zweites Zeitintervall in den zweiten Behälter.

In einem weiteren vorteilhaften Aspekt weist der zumindest eine erste und der zweite Behälter die zumindest eine Flüssigkeit und/oder deren Dampf auf.

Gemäß einem weiteren vorteilhaften Aspekt weist der zumindest eine erste Behälter eine andere Flüssigkeit auf als der zumindest eine weitere Behälter, dessen Flüssigkeit die erste Temperatur aufweist.

In einem weiteren bevorzugten Aspekt liegt die Anzahl des zumindest einen ersten Behälters in einem Bereich von 1 - 20, bevorzugt von 1 - 10 und am meisten bevorzugt von 1 - 3.

Gemäß einem weiteren Aspekt liegt eine Temperaturdifferenz der Flüssigkeiten in dem ersten Behälter und dem zumindest einen weiteren Behälter in einem Bereich von 10 °C - 250 °C, bevorzugt von 20 °C - 150 °C und am meisten bevorzugt von 30 °C - 100 °C.

In einem anderen Aspekt liegt die Temperaturdifferenz zwischen der zweiten Temperatur und der zumindest einen ersten Temperatur in einem Bereich von 1 °C - 150 °C, bevorzugt von 2 °C - 90 °C und am meisten bevorzugt von 3 °C - 30 °C.

In einem weiteren bevorzugten Aspekt weist das Werkstück zumindest einen Hohlraum auf, in den die zumindest eine Flüssigkeit eindringen kann.

Gemäß einem anderen Aspekt umfasst die Flüssigkeit eine aus Kohlenstoff, Fluor und Sauerstoff aufgebaute Flüssigkeit, insbesondere eine oder mehrere Perfluoropolyether-Flüssigkeiten.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung einer erfindungsgemäßen Vorrichtung darstellt;
- Fig. 2: einen schematischen Ablauf eines Erwärmungs- und Trocknungsvorgangs zeigt;
- Fig. 3: schematisch einen alternativen Ablauf eines Erwärmungs- und Trocknungsvorgangs wiedergibt;
- Fig. 4: schematisch die Temperaturen in den Behältern der Fig. 3 angibt;
- Fig. 5: die Vorrichtung der Fig. 3 zeigt, wobei im letzten Aufheizschritt ungesättigter Dampf eingesetzt wird;
- Fig. 6: eine schematische Darstellung eines alternativen Ausführungsbeispiels der Fig. 5 darstellt; und
- Fig. 7: eine schematische Darstellung der definierten Temperaturen veranschaulicht.

### 5. Detaillierte Beschreibung bevorzugter Ausführungsbeispiele

Im Folgenden werden bevorzugte Ausführungsformen der erfindungsgemäßen Vorrichtung genauer erläutert.

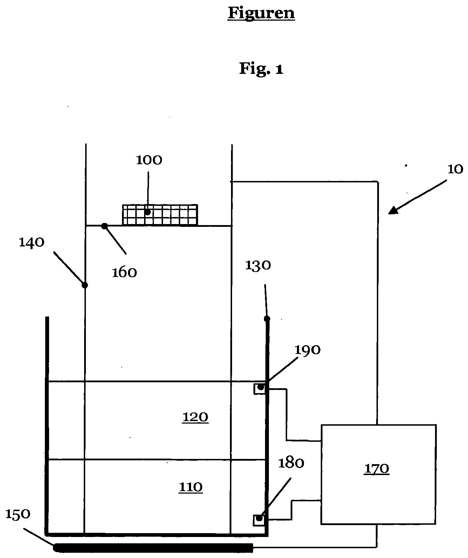

Die Fig. 1 zeigt schematisch einen Schnitt durch eine Vorrichtung 10 zur Erwärmung und Trocknung eines Werkstücks 100. In dem Behälter 130 befindet sich eine inerte, elektrisch nicht leitende Flüssigkeit 110. Der Behälter 130 kann aus einem beliebigen Material hergestellt werden, dessen Schmelztemperatur allerdings deutlich über der maximalen Temperatur liegen muss, auf die das Werkstück 100 aufgeheizt werden soll. Glatte Wände des Behälters 130 sind aus Reinigungsgründen und aus Gründen der Energiebilanz bevorzugt.

Die inerte Flüssigkeit 110 zeichnet sich dadurch aus, dass sie zumindest innerhalb des Temperaturbereichs des Aufheizvorgangs weder mit dem Werkstück 100 noch mit dem Behälter 130 oder einer anderen Komponente der Vorrichtung 10 eine chemische Reaktion ausführt. Darüber hinaus schützt sowohl die Flüssigkeit 110 als auch deren Dampf das Werkstück 100 während des Aufheizvorgangs zuverlässig vor Umwelteinflüssen, insbesondere vor dem Einwirken des Sauerstoffes aus der die Vorrichtung 10 umgebenden Atmosphäre.

Als Flüssigkeit 110 können alle Flüssigkeiten eingesetzt werden, die hinsichtlich des zu erwärmenden Werkstücks 100 inert sind, d.h. zumindest in dem Temperaturbereich des Erwärmungsprozesses nicht mit dem Werkstück 100 reagieren. Zudem muss die Flüssigkeit 110 die Eigenschaften eines elektrischen Isolators aufweisen. Für bestimmte Klassen von Werkstücken, beispielsweise glasartige oder keramische Werkstücke können beim Einsatz entsprechender Behälter 130 jedoch Flüssigkeiten eingesetzt werden, die die zuletzt genannte Forderung nicht erfüllen.

Darüber hinaus muss der Dampf der Flüssigkeit 110 eine Dichte aufweisen, die größer als die Dichte von Luft ist. Dadurch bildet sich über der siedenden Flüssigkeit 110 eine Dampfdecke 120 mit abgegrenzter Höhe.

Die Flüssigkeit 110 wird so gewählt, dass ihr Siedepunkt der Soll-Temperatur, d.h. der Temperatur auf die das Werkstück 100 erwärmt werden soll, entspricht oder der vorgegebenen Soll-Temperatur möglichst nahe kommt. In bevorzugten Ausführungsbeispielen der erfindungsgemäßen Vorrichtung 10 können auch Flüssigkeiten verwendet werden, deren Siedepunkte einige zehn Grad oberhalb der geforderten Soll-Temperatur liegen. Überdies lässt die erfindungsgemäße Vorrichtung 10 den Einsatz von Flüssigkeitsmischungen zu, um damit den Siedepunkt der Flüssigkeitsmischung an die geforderte Soll-Temperatur des heißen Werkstücks 100 anzupassen.

Als Flüssigkeiten, die die oben genannten Forderungen besonders gut erfüllen, kommen derzeit besonders Flüssigkeiten in Frage, die aus den Elementen Kohlenstoff, Sauerstoff und Fluor aufgebaut sind. Insbesondere Perfluoropolyether-Flüssigkeiten scheinen derzeit als inerte, elektrisch nicht leitende Flüssigkeit 110 vielversprechend. Die Siedepunkte dieser Perfluoropolyether-Flüssigkeiten decken zum jetzigen Zeitpunkt den Bereich von etwa 55 °C bis etwa 270 °C ab.

Ein weiterer wichtiger Vorteil dieser Perfluoropolyether-Flüssigkeiten liegt darin, dass sie in der Dampfphase eine inerte Atmosphäre mit hoher Dichte bilden, so dass auch deren Dampf das Werkstück 100 zuverlässig vor einer chemischen Reaktion beispielsweise vor einer Oxidation schützt. Aufgrund ihrer großen Dichte in der Dampfphase bilden die Perfluoropolyether-Flüssigkeiten, wie in der Fig. 1 dargestellt, eine abgegrenzte Dampfdecke 120 über der siedenden Flüssigkeit 110 oder auch als überhitzter oder ungesättigter Dampf.

Eine Heizvorrichtung 150, die in dem Beispiel der Fig. 1 unterhalb des Behälters 130 angeordnet ist, erwärmt die Flüssigkeit 110 von der Raumtemperatur ausgehend bis zum Siedepunkt der Flüssigkeit 110. In dem in der Fig. 1 dargestellten Beispiel ist es günstig, wenn zumindest der Boden des Behälters 130 thermisch gut leitend ausgeführt wird, um die Energie der Heizvorrichtung 150 mit großem Wirkungsgrad in die Flüssigkeit 110 zu übertragen. In einer Ausführungsform der Vorrichtung 10 bei der die Heizvorrichtung 150 in dem Behälter 130 angeordnet ist, ist es hingegen günstig, wenn die thermische Leitfähigkeit der Wände und des Bodens des Behälters 130 niedrig ist, um die Wärmeverluste durch den Behälter 130 zu minimieren.

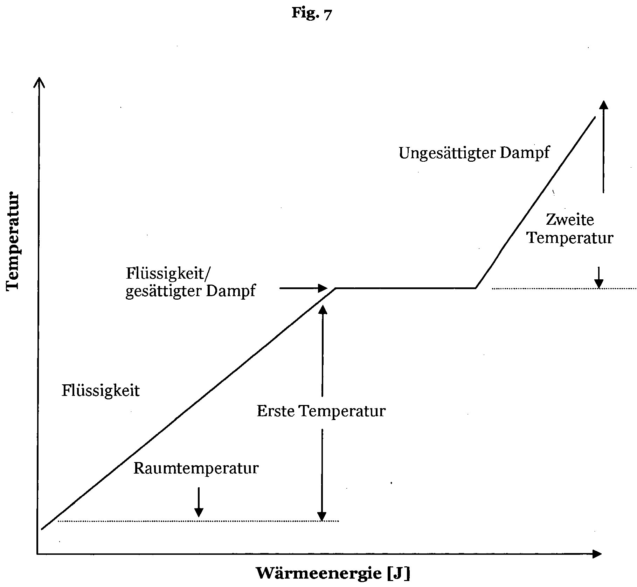

Mit einer Heizvorrichtung 150, die sich aus einer oder mehreren Heizungen zusammensetzen kann, wird die Flüssigkeit 110 zunächst bis zu ihrem Siedepunkt erwärmt. Bei weiterer Energiezufuhr in die siedende Flüssigkeit 110 steigt deren Temperatur nicht weiter an, sondern die Flüssigkeit 110 verdampft (siehe auf Fig. 7). Der entstehende Dampf bildet eine Dampfdecke 120 über der Flüssigkeit 110. Ein Teil des Dampfes kondensiert an den kalten Seitenwänden des Behälters 130 und erwärmt diese. Bei genügender Energiezufuhr durch die Heizvorrichtung 150 steigt die Dampfdecke 120 in dem Behälter 130 an.

Die Höhe der Dampfdecke hängt von der Leistungsaufnahme der Heizvorrichtung 150 ab. Die Höhe der Dampfdecke kann durch einen Sensor 190 gemessen werden. Es ist möglich mehrere Sensoren 190 einzusetzen, um die Höhe der Dampfdecke 120 mit größerer Präzision zu bestimmen (in der Fig. 1 nicht dargestellt). Alternativ oder zusätzlich kann der Sensor 190 in dem Behälter 130 in der Höhe verstellbar ausgeführt werden. In einer Ausführungsform ist der Sensor 190 ein Temperatursensor. Der Sensor 190 ist an eine Regelungseinheit 170 angeschlossen. Die Regelungseinheit 170 kann in Hardware, Software oder in einer Kombination aus Hardware und Software ausgeführt werden. Als Regelungseinheit 170 kann beispielsweise ein Mikroprozessor und/oder ein geeignetes Computersystem eingesetzt werden.

Die Temperatur der Flüssigkeit 110 kann durch einen weiteren Messfühler 180 bestimmt werden. Der Messfühler 180 kann beispielhaft ebenfalls als ein Temperatursensor ausgeführt werden. Der Messfühler 180 ist ebenfalls mit der Regelungseinheit 170 der Vorrichtung 10 verbunden. Darüber hinaus weist die Heizvorrichtung 150 eine Verbindung zu der Regelungseinheit 170 auf. Somit kann die Regelungseinheit 170 die Leistungsabgabe der Heizvorrichtung 150 gemäß einem vorgegebenen Temperaturprofil regeln. Anstelle der Regelungseinheit 170 kann in einem anderem Ausführungsbeispiel der Vorrichtung 10 eine Steuerung verwendet werden (in Fig. 1 nicht gezeigt). In diesem Ausführungsbeispiel der Vorrichtung 10 könnte auf die Sensoren 180 und 190 verzichtet werden. In einer weiteren alternativen Ausführungsform wird die Vorrichtung 10 ausschließlich manuell gesteuert, womit auf eine Steuerung oder die Regelungseinheit 170 verzichtet werden kann.

Zum Transport des Werkstücks 100 in den Behälter 130 hinein und aus diesem heraus wird das Werkstück 100 auf eine Aufnahme 160 der Positioniervorrichtung 140 aufgebracht. Als Positioniervorrichtung 140 können beispielsweise die bei Dampfphasen-Lötanlagen üblichen Transportvorrichtungen eingesetzt werden. Die Positioniervorrichtung 140 befördert das Werkstück 100 auf eine vorgegebene Höhe innerhalb des Behälters 130. Die Positioniervorrichtung 140 weist in der in der Fig. 1 dargestellten Ausführungsform ebenfalls eine Verbindung zu der Regelungseinheit 170 auf. Damit kann die Regelungseinheit 170 die Position des Werkstücks 100 in dem Behälter 130 entsprechend einem vorgegebenen Temperaturprofil variieren. In einer anderen Ausführungsform erfolgt der Transport des Werkstücks 100 unter der manuellen Kontrolle des Bedienpersonals der Vorrichtung 10.

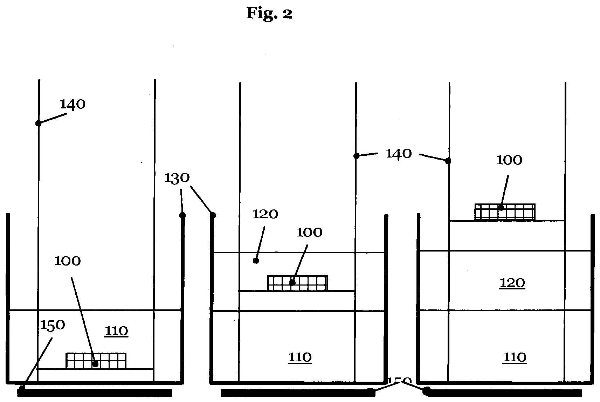

Die Fig. 2 zeigt schematisch den Ablauf eines Erwärmungs- und Trocknungsvorgangs in einer erfindungsgemäßen Vorrichtung 10. Im ersten Schritt bringt die Aufnahme 160 der Positioniervorrichtung 140 das auf der Aufnahme 160 angebrachte Werkstück 100 in die Flüssigkeit 110 ein (linkes Teilbild der Fig. 2). Beim Einbringen des Werkstücks 100 in die Flüssigkeit 110 weist dieses eine niedrige Temperatur auf wie etwa Raumtemperatur. Dadurch erfährt das Werkstück 100 beim Eintauchen in die Flüssigkeit 110 keine oder nur sehr geringe mechanische Spannungen. Sodann bildet die Regelungseinheit 170 (in Fig. 2 nicht gezeigt) ein vorgegebenes Temperaturprofil nach, indem sie die Heizleistung der Heizvorrichtung 150 anhand der momentanen Temperatur der Flüssigkeit 110, die mit Hilfe des in der Fig. 1 dargestellten Sensors 180 bestimmt wird, regelt. Da sich das Werkstück 100 während des Aufheizvorgangs ständig im thermischen Gleichgewicht mit der Flüssigkeit 110 befindet, sind die Spannungen, die das Werkstück 100 während des Erwärmungsprozesses erfährt, äußerst gering.

Bei Erreichen des Siedepunkts der Flüssigkeit 110, wiederum angezeigt durch den Sensor 180, bildet sich eine Dampfdecke 120 über der siedenden Flüssigkeit 110, wobei die Höhe der Dampfdecke 120 durch den in der Fig. 1 dargestellten Sensor 190 signalisiert wird. Die Positioniervorrichtung 140 hebt dann das Werkstück 100 aus der Flüssigkeit 110 in deren Dampfdecke 120 an (mittleres Teilbild der Fig. 2). In diesem Ausführungsbeispiel findet in der Dampfdecke 120 keine weitere Temperaturerhöhung des Werkstücks 100 statt. Vielmehr tropft die Flüssigkeit 110 bis auf einen dünnen Flüssigkeitsfilm, dessen Dicke durch die Oberflächenspannung oder vorhandene Kapillarkräfte bestimmt wird, von dem Werkstück 100 ab.

Nach Abschluss des Abtropfvorgangs befördert die Positioniervorrichtung 140 unter manueller Kontrolle oder unter der Kontrolle durch die Regelungseinheit 170 das Werkstück 100 aus der Dampfdecke 120 in die sich darüber befindliche Atmosphäre (rechtes Teilbild der Fig. 2). Unter Atmosphärenbedingungen (T ≈ 20 °C, P ≈ 1013 hPa) verdunstet der Flüssigkeitsfilm der Flüssigkeit 110 rasch und rückstandslos von der Oberfläche des Werkstücks 100. Das heiße Werkstück 100 ist nach kurzer Zeit vollständig trocken und steht für die nachfolgenden Bearbeitungsschritte zur Verfügung.

Das Werkstück 100 kann auch ohne Positionsänderung aus der Dampfdecke 120 befördert werden. Indem die Dampfdecke 120 auf ein Niveau unterhalb der Position des Werkstücks abgesenkt wird, beispielsweise durch Verringern oder Abschalten der Heizleistung, wird das Werkstück 100 ohne eigene Positionsänderung aus der Dampfdecke 120 befördert.

In diesem Ausführungsbeispiel der erfindungsgemäßen Vorrichtung 10 sollte die zweite Temperatur oder die Siedetemperatur der Flüssigkeit 110 der geforderten Soll-Temperatur des heißen Werkstücks 100 möglichst nahe kommen. Falls die Siedetemperatur der Flüssigkeit 110 den Toleranzbereich der Soll-Temperatur überschreitet, kann mit dem nachfolgenden Bearbeitungsschritt gewartet werden, bis sich die Oberfläche des Werkstücks 100 auf eine Temperatur innerhalb des Toleranzbereichs der Soll-Temperatur abgekühlt hat. Diese Wartezeit kann jedoch den gesamten Prozessablauf verlangsamen. Zudem sinkt die Energieeffizienz des Erwärmungsprozesses.

Ein möglicher nächster Prozess- oder Bearbeitungsschritt für das heiße trockene Werkstück 100 könnte beispielsweise das Aufbringen einer Lackschicht auf die Oberfläche des Werkstücks 100 sein, indem das heiße, trockene Werkstück 100 in ein Bad aus heißem flüssigen Lack getaucht wird. Nach dem Entfernen des Werkstücks 100 aus dem Lackbad bildet sich auf der Oberfläche des Werkstücks 100 beim Abkühlen durch Polymerisation eine schützende Lackschicht aus (in Fig. 2 nicht gezeigt). Für die Qualität der Lackschicht ist es von entscheidender Bedeutung, dass das heiße Werkstück 100 vor dem Einbringen in das Lackbad über seine gesamte Oberfläche trocken und frei von Flüssigkeitsresten ist. Nur dann kann ein einheitliches und ganzflächiges Benetzen des Lackes auf der Oberfläche des Werkstücks 100 erfolgen und nur unter dieser Voraussetzung kann sich eine qualitativ hochwertige Lackschicht ausbilden.

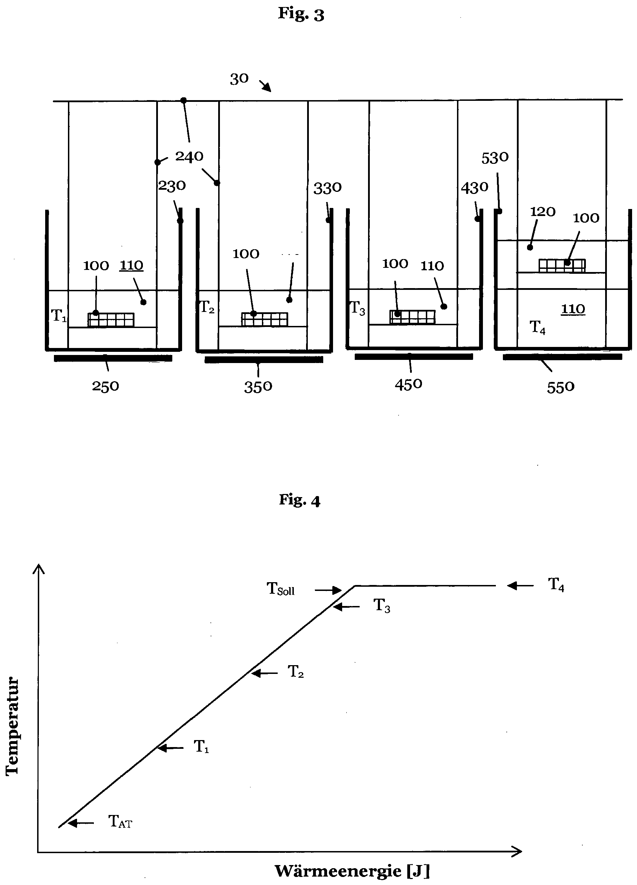

Die Fig. 3 präsentiert schematisch eine weitere derzeit bevorzugte Ausführungsform 30 der erfinderischen Vorrichtung. Anders als in den Figuren 1 und 2 weist die Vorrichtung 30 dieses Ausführungsbeispiels insgesamt vier Behälter 230, 330, 430 und 530 auf, die jeweils mit einer eigenen Heizvorrichtung 250, 350, 450 und 550 ausgestattet sind. Durch eine einzige Positioniervorrichtung 240 kann das Werkstück 100 zwischen den einzelnen Behältern 230, 330, 430 und 530 hin und her transportiert werden und in jeden der vier Behälter 230, 330, 430 und 530 auf eine einstellbare Höhe abgesenkt werden.

In dem Ausführungsbeispiel der Fig. 3 weist die Flüssigkeit 110 in jedem der Behälter 230, 330, 430 und 530 eine zeitlich konstante Temperatur T₁, T₂, T₃ und T₄ auf. Die Temperatur der Flüssigkeit 110 in den Behältern 230, 330, 430 und 530 steigt von links nach rechts stetig an. Die erste Temperatur T₁ der Flüssigkeit 110 in dem ersten Behälter 230 wird dabei so gewählt, dass das Werkstück 100, dessen Temperatur im Ausgangszustand bei Raumtemperatur liegt, beim Eintauchen in die Flüssigkeit 110 des ersten Behälters 230 eine definierte Temperaturdifferenz (T₁ - Raumtemperatur) erfährt und sich dadurch rasch auf die Temperatur T₁ der Flüssigkeit 110 in dem ersten Behälter 230 aufheizt. Bei der Wahl der Temperatur T₁ der Flüssigkeit 110 in dem ersten Behälter 230 wird streng darauf geachtet, dass die Temperaturdifferenz (T₁ - Raumtemperatur) in dem Werkstück 100 keine mechanischen Spannungen hervorruft, die das Werkstück 100 beschädigen können.

Der soeben beschriebene Vorgang wird für die Temperaturen T₂ und T₃ der Flüssigkeiten 110 in dem zweiten Behälter 330 und in dem dritten Behälter 430 wiederholt. Dabei entspricht die Temperatur T₃ der Flüssigkeit 110 des dritten Behälters 430 der ersten Temperatur und wird bevorzugt nur wenig (im Bereich von einigen °C) unterhalb der benötigten Soll-Temperatur des heißen Werkstücks 100 gewählt. Diese Wahl der Temperaturen T₁, T₂ und T₃ der Flüssigkeiten 110 in den Behältern 230, 330 und 430 sichert eine gute Energiebilanz des Erwärmungsvorgangs.

Sobald das Werkstück 100 die Temperatur T₃ des dritten Behälters 430 erreicht, befördert die Vorrichtung 240 das Werkstück 100 aus dem dritten Behälter 430 in die Dampfdecke 120 der in dem vierten Behälter 530 siedenden Flüssigkeit 110. In der Dampfdecke 120 des vierten Behälters 530 wird das Werkstück 100 um eine geringe Temperaturdifferenz (Soll-Temperatur - T₃) erwärmt und gleichzeitig tropft die Flüssigkeit 110, die das Werkstück 100 in der heißen Flüssigkeit 110 des dritten Behälters 430 aufgenommen hat, von der Oberfläche des Werkstücks 100 ab. Damit kann das Werkstück 100 unmittelbar nach Erreichen seiner Soll-Temperatur von der Positioniervorrichtung 240 aus der Dampfdecke 120 befördert werden. Wie bereits während der Diskussion der Fig. 2 ausgeführt, verdunstet der dünne Flüssigkeitsfilm rasch und rückstandsfrei von der gesamten Oberfläche des Werkstücks 100, wodurch ein trockenes Werkstück 100 bei der Soll-Temperatur zurückbleibt.

In einem erläuternden Beispiel soll das Werkstück 100 von der Raumtemperatur ausgehend auf eine Soll-Temperatur von 175 °C aufgeheizt werden. In diesem Beispiel könnte für die Temperatur T₁ der Flüssigkeit 110 in dem ersten Behälter 230 ein Wert von etwa 70 °C verwendet werden. Die Temperatur T₂ der Flüssigkeit 110 im zweiten Behälter 330 würde etwa 120 °C betragen und die Temperatur T₃ der Flüssigkeit 110 im dritten Behälter 430 würde entsprechend auf etwa 170 °C eingestellt. Die verbleibende Temperaturdifferenz von etwa 5 °C zwischen der Soll-Temperatur und der Temperatur T₃ würde in der Dampfdecke 120 des vierten Behälters 530 überbrückt.

Die Fig. 4 zeigt schematisch die verschiedenen Temperaturen der diskutierten Vorrichtung 30 der Fig. 3. In dem in der Fig. 4 dargestellten Beispiel liegt die Siedetemperatur T₄ der Flüssigkeit 110 knapp über der Soll-Temperatur T_{Soll}. Der Aufheizvorgang beginnt bei der Ausgangstemperatur T_{AT}, die mit der Raumtemperatur übereinstimmen kann.

In dem erläuterten Beispiel wird die Temperaturdifferenz (SollTemperatur - Raumtemperatur), die der Erwärmungsprozess überspannt im Wesentlichen gleichmäßig auf die Temperaturdifferenzen (T₃ - T₂), (T₂ - T₁ und (T₁ - Ausgangstemperatur) in den drei ersten Behältern 230, 330 und 430 aufgeteilt. Eine thermisch äquidistante Wahl der einzelnen Temperaturen T₁ bis T₄ ist vorteilhaft, da dadurch der Durchsatz der Vorrichtung 30 optimiert wird. Es ist jedoch auch denkbar, die Temperaturdifferenz (Soll-Temperatur - Ausgangstemperatur), ungleichmäßig auf die Temperaturdifferenzen (T₃ - T₂), (T₂ - T₁) und (T₁ - Ausgangstemperatur) der Flüssigkeiten 110 in den einzelnen Behältern 230, 330 und 430 aufzuteilen.

In der in der Fig. 3 dargestellten Ausführungsform 30 der erfindungsgemäßen Vorrichtung richtet sich die Anzahl der zum Aufheizen des Werkstücks 100 eingesetzten Behälter 230, 330, 430 und 530 zum einen nach der Höhe der durch den Erwärmungsprozess zu überbrückenden Temperaturdifferenz (Soll-Temperatur - Ausgangstemperatur) und zum anderen nach der dem Werkstück 100 zumutbaren Temperaturdifferenz (Tᵢ₊₁ - Tᵢ), bei der sichergestellt ist, dass das Werkstück 100 keinen Schaden erleidet.

In dem Ausführungsbeispiel der Fig. 3 muss die Siedetemperatur der Flüssigkeit 110 in dem vierten Behälter 530 nicht innerhalb des Toleranzbereichs der Soll-Temperatur des heißen Werkstücks 100 liegen. Entscheidend ist nur, dass die Temperatur T₃ der Flüssigkeit 110 in dem dritten Behälter 430 wenige Grad unterhalb der Soll-Temperatur des Werkstücks 100 liegt. Dadurch eröffnet das Ausführungsbeispiel der Fig. 3 bezüglich der Auswahl des Siedepunkts der Flüssigkeit 110 eine größere Freiheit als das in der Fig. 2 dargestellte Ausführungsbeispiel. Falls die Soll-Temperatur des Werkstücks 100 und die Temperatur in der Dampfdecke 120 oder die Siedetemperatur T₄ der Flüssigkeit 110 weiter auseinander liegen, kann die Zeitdauer des Werkstück 100 in der Dampfdecke 120 des vierten Behälters 530 manuell, durch eine Zeitsteuerung oder der in der Fig. 1 dargestellten die Regelungseinheit 170 kontrolliert werden (in der Fig. 3 nicht dargestellt).

Ein kurzes Zeitintervall des Werkstücks 100 in der Dampfdecke 120 der siedenden Flüssigkeit 110 des Behälter 530, um die Temperatur des Werkstücks 100 in der Dampfdecke 120 von der Temperatur T₃ der Flüssigkeit 110 des dritten Behälters 430 auf die Soll-Temperatur anzuheben, reicht aus, damit parallel zu dem Temperaturanstieg des Werkstücks 100 Flüssigkeitsansammlungen und/oder Flüssigkeitsreste von der Oberfläche des Werkstücks 100 abtropfen können.

Der Temperaturanstieg von der Ausgangstemperatur bis zu der Soll-Temperatur, sowie der Transport des Werkstücks 100 von und zu den einzelnen Behältern 230, 330, 430 und 530 kann manuell gesteuert werden oder unter der Kontrolle, der in der Fig. 1 gezeigten Regelungseinheit 170 mit Hilfe der Sensoren 180 und 190 und ggf. weiterer in der Fig. 1 nicht dargestellte Sensoren automatisch ablaufen (in der Fig. 3 nicht gezeigt).

Das anhand der Fig. 3 erläuterte Ausführungsbeispiel einer erfindungsgemäßen Vorrichtung 30 ermöglicht einen hohen Durchsatz an zu erwärmenden und zu trocknenden Werkstücken 100 und bildet somit eine wirtschaftlich attraktive Lösung des der Erfindung zugrunde liegenden Erwärmungs- und Trocknungsproblems.

In der in der Fig. 3 dargestellten Ausführungsform wird in allen vier Behältern 230, 30, 430, 530 die gleiche Flüssigkeit 110 verwendet. Diese Ausführungsform hat den Vorteil, dass es bei dem Transport des Werkstücks 100 durch die Positioniervorrichtung 240 von einem Behälter 230, 330 und 430 zum nächsten 330, 430 und 530 nicht zu Verschleppungsproblemen der Flüssigkeit 110 kommen kann.

Es ist jedoch auch denkbar in den ersten beiden Behältern 230 und 330 eine Flüssigkeit einzusetzen, die nicht der Flüssigkeit 110 in den beiden Behältern 430 und 530 entspricht. Dabei kann zudem die Flüssigkeit in dem ersten Behälter 230 verschieden von der Flüssigkeit in dem zweiten Behälter 330 sein und diese wiederum unterschiedlich zu der Flüssigkeit 110 in dem dritten 430 und dem vierten Behälter 530 sein. Der Einsatz einer zweiten Flüssigkeit kann insbesondere dann sinnvoll sein, wenn die Flüssigkeit 110 sehr teuer ist. Gegebenenfalls ist es bei dem Einsatz von zwei Flüssigkeiten notwendig nach dem ersten 230 bzw. nach dem zweiten Behälter 330 eine Trocknungsvorrichtung vorzusehen, um ein Verschleppen der Flüssigkeit des zweiten Behälters 330 in die Flüssigkeit 110 des dritten 430 und vierten Behälters 530 zu verhindern.

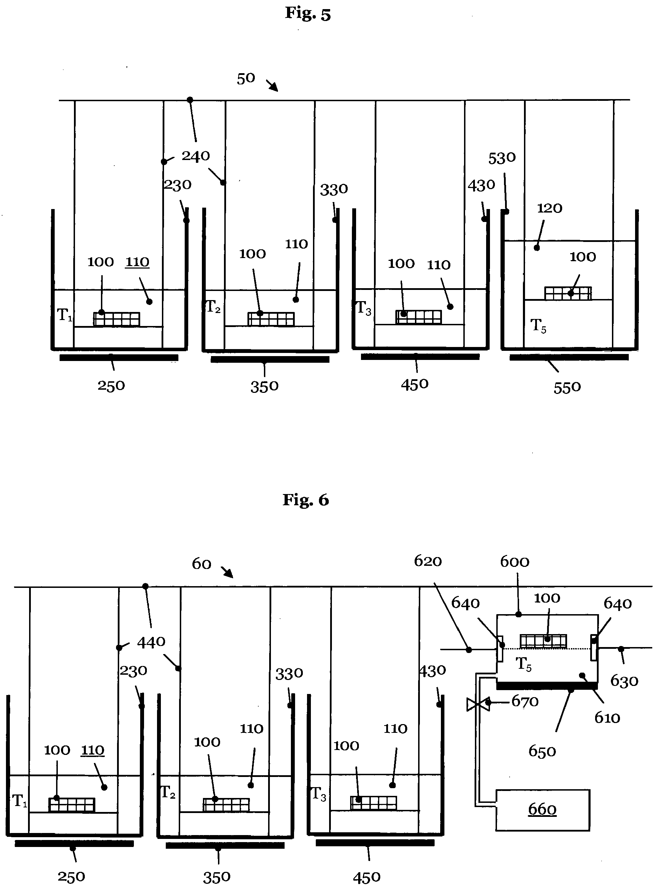

Die Fig. 5 zeigt nochmals die Vorrichtung 30 der Fig. 3 bei der der letzte Aufheizungsschritt von der ersten Temperatur zu der Soll-Temperatur nicht in einer Dampfdecke 120 über der siedenden Flüssigkeit 110 ausgeführt wird, sondern in einer Dampfdecke 120 aus ungesättigtem Dampf der Flüssigkeit 110. Da der Dampf der Flüssigkeit 110 eine deutlich größere Dichte als Luft aufweist, bildet auch der ungesättigte Dampf bei einer Temperatur T₅ oberhalb der Siedetemperatur der Flüssigkeit 110 eine Dampfdecke 120. Der ungesättigte Dampf kann durch Verdampfen der Flüssigkeit 110 in dem Behälter 430 und weiterer Energiezufuhr in den Behälter 430 nach dem Verdampfen erfolgen. Dampfverluste im Laufe des Prozesses können durch Zugabe von heißer Flüssigkeit 110 in den Behälter 430 kompensiert werden. Die heiße Flüssigkeit verdampft rasch von dem heißen Boden des Behälters 430. In einer alternativen Ausführungsform kann bereits der Dampf der Flüssigkeit steuer- oder regelbar in den Behälter 430 eingebracht werden (in Fig. 5 nicht gezeigt).

Indem das Werkstück 100 den letzten Aufheizschritt in ungesättigtem Dampf ausführt, kann die Soll-Temperatur oberhalb der Siedetemperatur der Flüssigkeit 110 gewählt werden. Dadurch wird der Temperaturbereich eines erfindungsgemäßen Aufheizvorgangs über die Siedetemperatur der Flüssigkeit 110 hinaus vergrößert. Das Durchführen des letzten Aufheizschrittes in ungesättigtem Dampf bietet sich für schöpfende Werkstücke 100 an. In die Hohlräume oder Kavitäten dieser Werkstücke 100 dringt in dem Flüssigkeitsbad der Behälter 230, 330 und 430 während des ersten Aufheizschrittes Flüssigkeit ein. Erreicht das Werkstück 100 in der ungesättigten Dampfdecke 120 des Behälters 430 der Fig. 5 die Siedetemperatur der Flüssigkeit, dann beginnt Flüssigkeit aus den Hohlräumen bzw. Kavitäten des Werkstücks 100 zu verdampfen. Während des Aufheizschrittes bis zur Soll-Temperatur verdampfen die Flüssigkeitsansammlungen oder Flüssigkeitsreste auf den Hohlräumen des Werkstücks. Damit ist auch ein schöpfendes Werkstück 100, dessen Soll-Temperatur über der Siedetemperatur der Flüssigkeit liegt, nach dem Herausnehmen aus der Dampfdecke 120 trocken.

Die Fig. 6 zeigt eine alternative Ausführungsform der Vorrichtung 50 der Fig. 5 bei der der letzte Aufheizungsschritt von der ersten Temperatur zu der Soll-Temperatur ebenfalls in dem ungesättigten Dampf 610 der Flüssigkeit 110 ausgeführt wird. Die Vorrichtung 60 der Fig. 6 zeigt anstelle des Behälters 530 einen gasdichten Behälter 600, der ungesättigten Dampf 610 der Flüssigkeit 110 enthält. Sobald das Werkstück 100 in dem dritten Behälter 430 die erste Temperatur erreicht hat, befördert die Positioniervorrichtung 440 das Werkstück 100 über die Beladungsvorrichtung 620 und die Schleuse 640 in das Innere des gasdichten Behälters 600.

Die Temperatur T₆ des Gases oder des ungesättigten Dampfes 610 der Flüssigkeit 110 in dem gasdichten Behälter 600 liegt oberhalb der Siedetemperatur der Flüssigkeit 110. Mit einer Heizung 650, die in dem Ausführungsbeispiel der Fig. 6 unterhalb des gasdichten Behälters 600 angeordnet ist, kann die Gastemperatur T₆ über einen großen Temperaturbereich variiert werden. Damit kann zum einen das Zeitintervall für den letzten Aufheizschritt in dem gasdichten Behälter 600 eingestellt werden und zum anderen kann damit die Temperatur T₆ an die Soll-Temperatur des Werkstücks 100 angepasst werden. In einer alternativen Ausführungsform des gasdichten Behälters 600 ist die Heizung 650 in dem Inneren des gasdichten Behälters 600 angeordnet.

Die Beschränkung der Soll-Temperatur des Ausführungsbeispiels der Fig. 3 auf die Siedetemperatur der Flüssigkeit 110 entfällt damit weitgehend. In dem gasdichten Behälter 600 kann das Werkstück 100 auf eine fast beliebige Soll-Temperatur aufgeheizt werden. Aus energetischen Gründen und um den Durchsatz der Vorrichtung 60 hoch zu halten, ist es jedoch vorteilhaft, wenn die Temperaturdifferenz zwischen der Soll-Temperatur und der ersten Temperatur, ähnlich wie anhand der Fig. 3 diskutiert, nur wenig Grad Celsius beträgt. Dies bedeutet für das Erwärmen eines Werkstücks 100 mit einer Soll-Temperatur oberhalb der Siedetemperatur der Flüssigkeit 110 eine inerte, elektrisch nicht leitende Flüssigkeit einzusetzen, deren Siedepunkt der Soll-Temperatur möglichst nahe kommt.

Nach dem Erreichen der Soll-Temperatur schleust die Positioniervorrichtung 440 das trockene Werkstück 100 über die Schleuse 640 und die Entladungsvorrichtung 630 aus dem gasdichten Behälter 600 aus.

Der gasdichte Behälter 600 steht über das Ventil 670 in Verbindung mit einer Gasquelle 660. Die Gasquelle 660 kann Gasverluste, die durch Einschleusungs- und Ausschleusungsvorgänge in dem gasdichten Behälter 600 entstehen kompensieren.

Die Fig. 7 zeigt schließlich die Temperatur der Flüssigkeit 110 und ihres Dampfes als Funktion der der Flüssigkeit bzw. dem Dampf zugeführten Wärmemenge. Im Bereich der ersten Temperatur liegt die Flüssigkeit 110 in Form einer Flüssigkeit vor. Beim Ausbilden einer Dampfdecke 120 über der siedenden Flüssigkeit 110 existiert die Flüssigkeit 110 in Koexistenz mit ihrem gesättigten Dampf. In dem Temperaturbereich oberhalb der Siedetemperatur weist die Flüssigkeit 110 die Form eines ungesättigten Dampfes auf.

In einer weiteren alternativen Ausführungsform wird das Werkstück 100 in der Flüssigkeit 110 bis zur Soll-Temperatur erwärmt und das Trocknen des erwärmten Werkstücks 100 geschieht in einer separaten Trocknungsvorrichtung. Letztere kann beispielsweise eine Vakuumkammer umfassen, in die das heiße Werkstück 100 gebracht wird. Durch das Erzeugen eines Unterdrucks verdunstet die Flüssigkeit 110 rasch von der Oberfläche des Werkstücks 100. Diese Aufführungsform kann insbesondere zum Trocknen von schöpfenden Werkstücken 100 günstig sein. (Diese Ausführungsform ist in keiner der beiliegenden Figuren veranschaulicht.)

In einem anderen Ausführungsbeispiel wird die Trocknungsvorrichtung durch eine Absaugvorrichtung realisiert, insbesondere durch einen Nasssauger. Eine weitere Ausführungsform der Trocknungsvorrichtung umfasst einen Gasstrom, der auf das zu trocknende Werkstück 100 gerichtet wird. Um ein Abkühlen des heißen Werkstücks 100 während des Trocknens zu verhindern, kann der Gasstrom auf eine Temperatur bis zur Soll-Temperatur erwärmt werden.

Schließlich ist es möglich den Abtropfvorgang in dem gesättigten Dampf bzw. den Trocknungsvorgang in dem ungesättigten Dampf der Flüssigkeit mit einem Trocknungsschritt in einer separaten Trocknungsvorrichtung zu kombinieren. Mögliche Ausführungsformen einer Trocknungsvorrichtung sind in den beiden vorangehenden Abschnitten beispielhaft beschrieben. Dabei erfolgt das Trocknen in der separaten Trocknungsvorrichtung als abschließender Schritt des gesamten Erwärmungs- und Trocknungsprozesses. Ähnlich wie bereits oben ausgeführt, kann diese Aufführungsform insbesondere das Trocknen von schöpfenden bzw. stark schöpfenden Werkstücken 100 beschleunigen. Dadurch kann sichergestellt werden, dass auch diese Werkstücke nach dem Trocknungsvorgang noch immer im Wesentlichen die geforderte Soll-Temperatur aufweisen.

## Patentansprüche

1. Vorrichtung (10, 30, 50) zum Erwärmen und zum Trocknen eines Werkstücks (100) mit Hilfe zumindest einer inerten, elektrisch nicht leitenden Flüssigkeit (110) und deren Dampf, wobei der Dampf der zumindest einen inerten, elektrisch nicht leitenden Flüssigkeit (110) eine höhere Dichte als Luft aufweist, die Vorrichtung aufweisend:
a. zumindest einen Behälter (130, 230, 330, 430, 530), der ausgebildet ist, die zumindest eine Flüssigkeit (110) und/oder deren Dampfdecke (120) und das Werkstück (100) aufzunehmen;
b. zumindest eine Positioniervorrichtung (140, 240), die ausgebildet ist, das Werkstück (100) in den zumindest einen Behälter (130, 230, 330, 430, 530) einzubringen und wieder aus dem zumindest einen Behälter (130, 230, 330, 430, 530) zu entfernen;
c. zumindest eine Heizvorrichtung (150, 250, 350, 450, 550), die ausgebildet ist, die zumindest eine Flüssigkeit (110) auf zumindest eine erste Temperatur und auf eine zweite Temperatur zu erwärmen, wobei die zumindest eine Flüssigkeit (110) bei der zweiten Temperatur eine Dampfdecke (120) bildet, und wobei die zumindest eine Flüssigkeit (110) bei der ersten Temperatur in Form einer Flüssigkeit vorliegt, wobei die Heizvorrichtung (150, 250, 350, 450, 550) ferner eine Steuerungseinheit aufweist, die ausgebildet ist, einen Temperaturanstieg der zumindest einen Flüssigkeit (110) bis zu der zweiten Temperatur nach einem vorgegebenen Temperaturprofil zu steuern, oder wobei die Heizvorrichtung (150, 250, 350, 450, 550) ferner eine Regelungseinheit (170) aufweist, die ausgebildet ist, den Temperaturanstieg der zumindest einen Flüssigkeit (110) bis zu der zweiten Temperatur gemäß einem vorgegebenen Temperaturprofil nachzubilden;
d. wobei die Positioniervorrichtung (140, 240) ferner ausgebildet ist, das Werkstück (100) aus der zumindest einen Flüssigkeit (110) in die Dampfdecke (120) der zumindest einen Flüssigkeit (110) zu befördern, wenn das Werkstück (100) die zumindest eine erste Temperatur erreicht hat; und
e. wobei die Vorrichtung (10, 30, 50) ausgebildet ist, das Werkstück (100) nach Erreichen einer vorgegebenen Soll-Temperatur aus der Dampfdecke (120) zu befördern.

2. Vorrichtung (10, 30, 50) nach Anspruch 1, wobei die Dampfdecke (120) gesättigten Dampf der zumindest einen Flüssigkeit (110) aufweist und die zweite Temperatur der Siedetemperatur der zumindest einen Flüssigkeit (110) entspricht oder die Dampfdecke (120) ungesättigten Dampf der zumindest einen Flüssigkeit (110) umfasst und die zweite Temperatur oberhalb der Siedetemperatur der zumindest einen Flüssigkeit (110) liegt.

3. Vorrichtung (10, 30, 50) nach Anspruch 1 oder 2, wobei die Heizvorrichtung (150, 250, 350, 450, 550) ausgebildet ist, die zumindest eine Flüssigkeit (110) von einer Raumtemperatur ausgehend auf die zumindest eine erste und die zweite Temperatur zu erwärmen.

4. Vorrichtung (10, 30, 50) nach einem der vorhergehenden Ansprüche, wobei der zumindest eine Behälter (130) zumindest einen ersten (230, 330, 430) und einen zweiten Behälter (530) aufweist, wobei eine Temperatur der zumindest einen Flüssigkeit (110) in dem zumindest einen ersten Behälter (230, 330, 430) der zumindest einen ersten Temperatur entspricht und eine Temperatur der zumindest einen Flüssigkeit (110) in dem zweiten Behälter (530) der zweiten Temperatur entspricht.

5. Vorrichtung (30, 50) nach Anspruch 4, wobei der zumindest eine erste Behälter (230) zumindest einen weiteren Behälter (330, 430) umfasst, dessen Flüssigkeit eine Temperatur aufweist, die zwischen einer Ausgangstemperatur und der zumindest einen ersten Temperatur der zumindest einen Flüssigkeit (110) liegt.

6. Vorrichtung (30, 50) nach Anspruch 4 oder 5, wobei die Positioniervorrichtung (140, 240) ausgebildet ist, das Werkstück (100) für zumindest ein erstes Zeitintervall in den zumindest einen ersten Behälter (230, 330, 430) zu befördern und nach Ablauf des zumindest einen ersten Zeitintervalls das Werkstück (100) für ein zweites Zeitintervall in den zweiten Behälter (530) zu befördern.

7. Vorrichtung (30, 50) nach einem der Ansprüche 4 - 6, wobei der zumindest eine erste (230, 330, 430) und der zweite Behälter (530) die zumindest eine Flüssigkeit (110) und/oder deren Dampf aufweisen.

8. Vorrichtung (30, 50) nach einem der Ansprüche 4 - 7, wobei der zumindest eine erste Behälter (230, 330) eine andere Flüssigkeit aufweist als der zumindest eine weitere Behälter (430), dessen Flüssigkeit (110) die erste Temperatur aufweist.

9. Vorrichtung (30, 50) nach einem der Ansprüche 4 - 8, wobei die Anzahl des zumindest einen ersten Behälters (230, 330, 430) in einem Bereich von 1 - 20, bevorzugt von 1 - 10 und am meisten bevorzugt von 1 - 3 liegt.

10. Vorrichtung (30, 50) nach einem der Ansprüche 4 - 9, wobei eine Temperaturdifferenz der Flüssigkeiten in dem ersten Behälter (230, 330) und dem zumindest einen weiteren Behälter (330, 430) in einem Bereich von 10 °C - 250 °C, bevorzugt von 20 °C - 150 °C und am meisten bevorzugt von 30 °C - 100 °C liegt.

11. Vorrichtung (30) nach einem der vorhergehenden Ansprüche, wobei die Temperaturdifferenz der Flüssigkeit (110) zwischen der zweiten Temperatur und der zumindest einen ersten Temperatur in einem Bereich von 1 °C - 150 °C, bevorzugt von 2 °C - 90 °C und am meisten bevorzugt von 3 °C - 30 °C liegt.

12. Vorrichtung (10, 30, 50) nach einem der vorhergehenden Ansprüche, wobei das Werkstück (100) zumindest einen Hohlraum aufweist, in den die zumindest eine Flüssigkeit (110) eindringen kann.

13. Vorrichtung (10, 30, 50) nach einem der vorhergehenden Ansprüche, wobei die Flüssigkeit (110) eine aus Kohlenstoff, Fluor und Sauerstoff aufgebaute Flüssigkeit, insbesondere eine oder mehrere Perfluoropolyether-Flüssigkeiten umfasst.

## Claims

1. A device (10, 30, 60) for heating and for drying a work piece (100) by means of at least one inert, electrical non-conductive liquid (110) and its steam, wherein the steam of the at least one inert, electrical non-conductive liquid (110) comprises a higher density than air, the device comprising:
a. at least one container (130, 230, 330, 430, 530) that is adjusted to receive the at least one liquid (110) and/or its steam cover (120) and the work piece (100);
b. at least one positioning device (140, 240) that is adjusted to insert the work piece (100) into the at least one container (130, 230, 330, 430, 530) and to remove it again from the at least one container (130, 230, 330, 430, 530);
c. at least one heating device (150, 250, 350, 450, 550) that is adjusted to heat the at least one liquid (110) to at least a first temperature and a second temperature, wherein the at least one liquid (110) forms a steam cover (120) at the second temperature, and wherein the at least one liquid (110) is in the form of a liquid at the first temperature, wherein the heating device (150, 250, 350, 450, 550) further comprises a control unit, that is adjusted to control a temperature increase of the at least one liquid (110) to the second temperature according to a predetermined temperature profile, or wherein the heating device (150, 250, 350, 450, 550) further comprises a regulation unit (170) that is adjusted to follow the temperature increase of the at least one liquid (110) to the second temperature according to a predetermined temperature profile;
d. wherein the positioning device (140, 240) is further adjusted to advance the work piece (100) from the at least one liquid (110) into the steam cover (120) of the at least one liquid (110), if the work piece (100) has reached the at least one first temperature; and
e. wherein the device (10, 30, 50) is adjusted to advance the work piece (100) from the steam cover (120) after reaching a predetermined nominal temperature.

2. The device (10, 30, 50) according to claim 1, wherein the steam cover (120) comprises saturated steam of the at least one liquid (110) and the second temperature corresponds to the boiling temperature of the at least one liquid (110) or the steam cover (120) comprises unsaturated steam of the at least one liquid (110) and the second temperature is above the boiling temperature of the at least one liquid (110).

3. The device (10, 30, 50) according to claim 1 or 2, wherein the heating device (150, 250, 350, 450, 550) is adjusted to heat the at least one liquid (110) from a room temperature to the at least one first and the second temperature.

4. The device (10, 30, 50) according to any one of the preceding claims, wherein the at least one container (130) comprises at least a first (230, 330, 430) and a second container (530), wherein a temperature of the at least one liquid (110) in the at least one first container (230, 330, 430) corresponds to the at least one first temperature and a temperature of the at least one liquid (110) in the second container (530) corresponds to the second temperature.

5. The device (30, 50) according to claim 4, wherein the at least one first container (230) comprises at least one further container (330, 430) whose liquid comprises a temperature that is between an initial temperature and the at least one first temperature of the at least one liquid (110).

6. The device (30, 50) according to claim 4 or 5, wherein the positioning device (140, 240) is adjusted to advance the work piece (100) for at least a first time interval into the at least one first container (230, 330, 430) and to advance the work piece (100) for a second time interval into the second container (530) at the end of the at least one first time interval.

7. The device (30, 50) according to one of the claims 4 - 6, wherein the at least one first (230, 330, 430) and the second container (530) comprise the at least one liquid (110) and/or its steam.

8. The device (30, 50) according to one of the claims 4 - 7, wherein the at least one first container (230, 330) comprises a different liquid than the at least one further container (430), whose liquid (110) comprises the first temperature.

9. The device (30, 50) according to one of the claims 4 - 8, wherein the number of the at least one first container (230, 330, 430) is in a region of 1 - 20, preferably of 1 - 10 and most preferably of 1 - 3.

10. The device (30, 50) according to one of the claims 4 - 9, wherein a temperature difference of the liquids in the first container (230, 330) and the at least one further container (330, 430) is in a region of 10 °C - 250 °C, preferably of 20 °C - 150 °C and most preferably of 30 °C - 100 °C.

11. The device (30) according to any one of the preceding claims, wherein the temperature difference of the liquid (110) is between the second temperature and the at least one first temperature in a region of 1 °C - 150 °C, preferably of 2 °C - 90 °C and most preferably of 3 °C - 30 °C.

12. The device (10, 30, 50) according to any one of the preceding claims, wherein the work piece (100) comprises at least one cavity in which the at least one liquid (110) may ingress.

13. The device (10, 30, 50) according to any one of the preceding claims, wherein the liquid (110) comprises a liquid composed of carbon, fluor and oxygen, in particular one or more perfluoropolyether-liquids.

## Revendications

1. Dispositif (10, 30, 50) pour chauffer et pour sécher une pièce (100) à l'aide d'au moins un liquide inerte, électriquement non conducteur (110) et de sa vapeur, la vapeur du au moins un liquide inerte, électriquement non conducteur (110) présentant une densité supérieure à l'air, le dispositif comprenant :
a. au moins un récipient (130, 230, 330, 430, 530) qui est conçu pour recevoir au moins un liquide (110) et/ou sa couverture de vapeur (120) et la pièce (100);
b. au moins un dispositif de positionnement (140, 240) qui est conçu pour introduire la pièce (100) dans le au moins un récipient (130, 230, 330, 430, 530) et la retirer du au moins un récipient (130, 230, 330, 430, 530) ;
c. au moins un dispositif de chauffage (150, 250, 350, 450, 550) qui est conçu pour chauffer le au moins un liquide (110) à au moins une première température et à une seconde température, le au moins un liquide (110) formant, à la seconde température, une couverture de vapeur (120), et le au moins un liquide (110) se présentant, à la première température, sous forme de liquide, le dispositif de chauffage (150, 250, 350, 450, 550) comportant en outre une unité de commande qui est conçue pour commander une élévation de température du au moins un liquide (110) jusqu'à la seconde température selon un profil de température prédéfini, ou le dispositif de chauffage (150, 250, 350, 450, 550) comportant en outre une unité de régulation (170) qui est conçue pour reproduire l'élévation de température du au moins un liquide (110) jusqu'à la seconde température conformément à un profil de température prédéfini ;
d. le dispositif de positionnement (140, 240) étant en outre conçu pour transférer la pièce (100) du au moins un liquide (110) dans la couverture de vapeur (120) du au moins un liquide (110) quand la pièce (100) a atteint la au moins une première température ; et
e. le dispositif (10, 30, 50) étant conçu pour transférer la pièce (100) hors de la couverture de vapeur (120) après atteinte d'une température de consigne prédéfinie.

2. Dispositif (10, 30, 50) selon la revendication 1, la couverture de vapeur (120) comportant de la vapeur saturée du au moins un liquide (110), et la seconde température correspondant à la température d'ébullition du au moins un liquide (110), ou la couverture de vapeur (120) comprenant de la vapeur non saturée du au moins un liquide (110), et la seconde température étant supérieure à la température d'ébullition du au moins un liquide (110).

3. Dispositif (10, 30, 50) selon la revendication 1 ou 2, le dispositif de chauffage (150, 250, 350, 450, 550) étant conçu pour chauffer le au moins un liquide (110), à partir d'une température ambiante, à la au moins une première ou la seconde température.

4. Dispositif (10, 30, 50) selon une des revendications précédentes, le au moins un récipient (130) comportant au moins un premier (230, 330, 430) et un second récipient (530), une température du au moins un liquide (110) dans le au moins un premier récipient (230, 330, 430) correspondant à la au moins une première température, et une température du au moins un liquide (110) dans le second récipient correspondant (530) correspondant à la seconde température.

5. Dispositif (30, 50) selon la revendication 4, le au moins un premier récipient (230) comprenant un récipient supplémentaire (330, 430) dont le liquide présente une température qui est située entre la température initiale et la au moins une première température du au moins un liquide (110).

6. Dispositif (30, 50) selon la revendication 4 ou 5, le dispositif de positionnement (140, 240) étant conçu pour amener la pièce (100) pendant au moins un premier intervalle de temps dans le au moins un premier récipient (230, 330, 430) et, après écoulement du au moins un premier intervalle de temps, pour amener la pièce (100) pendant un second intervalle de temps dans le second récipient (530).

7. Dispositif (30, 50) selon une des revendications 4 à 6, le au moins un premier récipient (230, 330, 430) et le second récipient (530) comportant le au moins un liquide (110) et/ou sa vapeur.

8. Dispositif (30, 50) selon une des revendications 4 à 7, le au moins un premier récipient (230, 330) comportant un liquide autre que celui du au moins un récipient supplémentaire (430), dont le liquide (110) présente la première température.

9. Dispositif (30, 50) selon une des revendications 4 à 8, le nombre du au moins un premier récipient (230, 330, 430) se situant dans une plage de 1 à 20, de préférence de 1 à 10 et, le plus préférablement, de 1 à 3.

10. Dispositif (30, 50) selon une des revendications 4 à 9, une différence de température des liquides dans le premier récipient (230, 330) et dans le au moins un récipient supplémentaire (330, 430) se situant dans une plage de 10 °C à 250 °C, de préférence de 20 °C à 150 °C et, le plus préférablement, de 30 °C à 100 °C.

11. Dispositif (30) selon une des revendications précédentes, la différence de température du liquide (110) entre la seconde température et la au moins une première température se situant dans une plage de 1 °C à 150 °C, de préférence de 2 °C à 90 °C et, le plus préférablement, de 3 °C à 30 °C.

12. Dispositif (10, 30, 50) selon une des revendications précédentes, la pièce (100) comportant au moins une cavité dans laquelle le au moins un liquide (110) peut pénétrer.

13. Dispositif (10, 30, 50) selon une des revendications précédentes, le liquide (110) comprenant un liquide constitué de carbone, de fluor et d'oxygène, en particulier un ou plusieurs liquides à base de perfluoropolyéther.
